(19) Europäisches Patentamt
European Patent Office
Office européen des brevets

(11) **EP 4 415 268 A1**

(12) **EUROPEAN PATENT APPLICATION**

(43) Date of publication:
**14.08.2024  Bulletin 2024/33**

(21) Application number: **23156114.3**

(22) Date of filing: **10.02.2023**

(51) International Patent Classification (IPC):
**H03M 1/10** *(2006.01)*      **H03M 1/14** *(2006.01)*
**H03M 3/00** *(2006.01)*

(52) Cooperative Patent Classification (CPC):
**H03M 1/1033;** H03M 1/14; H03M 3/414

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **NXP B.V.**
**5656 AG Eindhoven (NL)**

(72) Inventors:
• **Hardeman,, Gijsbert Willem**
**5656 AG Eindhoven (NL)**

• **Rutten,, Robert**
**5656 AG Eindhoven (NL)**
• **Pol,, Evert-Jan Daniel**
**5656 AG Eindhoven (NL)**
• **Liu,, Qilong**
**5656 AG Eindhoven (NL)**
• **Bajoria,, Shagun**
**5656 AG Eindhoven (NL)**
• **Breems,, Lucien Johannes**
**5656 AG Eindhoven (NL)**

(74) Representative: **Krott, Michel**
**NXP Semiconductors**
**Intellectual Property Group**
**High Tech Campus 60**
**5656 AG  Eindhoven (NL)**

(54) **A DETECTOR DEVICE**

(57)      A detector device for calibrating a digital filter to replicate a transfer function of a signal processing apparatus, comprising: a first input to receive a first signal; a second input configured to receive a response signal of the signal processing apparatus to the first signal; a controllable FIR filter; a comparison-block to compare the phase and amplitude after a correction has been applied by the controllable FIR filter; a feedback loop; and an interpolation-block; wherein the at least one detector is configured to determine, at least, the feedback control signal at a first frequency and at a second frequency, and wherein the interpolation-block is configured to interpolate to determine calibration information for programming of the transfer function of said digital filter.

Fig. 4

**Description**

<u>Field</u>

The present disclosure relates to a detector device. In one or more examples, it relates to a detector device for determining a transfer function of a signal processing device and deriving calibration data to program a digital filter to replicate the transfer function. The present disclosure also relates to a combination of the detector device and a continuous-time pipelined analog to digital convertor.

**Background**

A transfer function represents the effect a signal processing device of one or more components has on a signal, such as in terms of its amplitude and/or phase. It may be desirable to measure the transfer function. A digital filter may be programmed to replicate the transfer function of other signal processing components. However, deriving the transfer function such that the digital filter can be programmed in a time-efficient manner is a challenge.

**Summary**

According to a first aspect of the present disclosure there is provided a detector device for calibrating a digital filter to replicate a transfer function of a signal processing apparatus, the detector device comprising at least one detector comprising:

> a first input configured to receive a first signal;
> a second input configured to receive a response signal comprising a response of the signal processing apparatus to the first signal;
> a controllable finite-impulse-response, FIR, filter;
> a frequency selection block for control of the frequency of the first signal;
> a comparison-block comprising one or both of a phase comparator and an amplitude comparator, wherein the phase comparator is configured to provide a first output indicative of a phase difference between the first signal, after a correction has been applied by the controllable FIR filter, and the response signal and the amplitude comparator is configured to provide a second output indicative of an amplitude difference between the first signal, after a correction has been applied by the controllable FIR filter, and the response signal;
> a feedback loop including the controllable FIR filter, wherein the controllable FIR filter has at least two taps and is coupled between the first input and the comparison block and is configured to selectively apply the correction to the first signal, and wherein the feedback loop is configured to, based on the output of the phase comparator and the output of the amplitude comparator, provide a feedback control signal to control the at least two taps to reduce the phase difference indicated by the first output and the amplitude difference indicated by the second output; and
> an interpolation-block;
> wherein the at least one detector is configured to determine, at least, the feedback control signal at a first frequency and the feedback control signal at a second frequency, different to the first frequency, and wherein the interpolation-block is configured to interpolate at least between the first frequency and the second frequency to determine calibration information for programming of the transfer function of said digital filter based on at least a first frequency domain sample derived from the feedback control signal at the first frequency and a second frequency domain sample derived from the feedback control signal at the second frequency.

In one or more examples, the detector device includes a frequency selection block for control of the frequency of the first signal such that the feedback control signal at the first frequency and the feedback control signal at the second frequency can be determined. The frequency selection block may be provided at the input to the comparison-block to control the frequency of the first signal, after a correction has been applied by the controllable FIR filter, and the response signal provided thereto.

In one or more embodiments, the first signal comprise one of:

> white noise;
> coloured noise;
> a signal having frequency components at the at least first frequency and the second frequency;
> a signal having frequency components at the first frequency at a first time and frequency components at the second frequency at a second, different time;
> one or more sine waves; and

one or more square waves.

In one or more embodiments, the feedback control signal at the first frequency defines the at least two-taps of the finite-impulse-response filter that replicates the transfer function at the first frequency and the feedback control signal at the second frequency defines the at least two-taps of the finite-impulse-response filter that replicates the transfer function at the second frequency, and wherein the detector is configured to determine the first frequency domain sample by determining a discrete Fourier transform of the feedback control signal at the first frequency and is configured to determine the second frequency domain sample by determining a discrete Fourier transform of the feedback control signal at the second frequency; and
the interpolation-block is configured to apply an interpolation algorithm that determines, based on the first frequency domain sample and the second frequency domain sample and by interpolation, the calibration information, wherein the calibration information represents the transfer function of the signal processing apparatus at the first frequency and the second frequency and the transfer function interpolated therebetween.

In one or more embodiments, the detector device is configured to determine the feedback control signal at the first frequency and the feedback control signal at the second frequency sequentially.

In one or more embodiments, the frequency selection block comprises a controllable mixer arrangement comprising:

a first programmable digital mixer and a first low-pass-filter, wherein the first programmable digital mixer is configured to receive the output of the finite-impulse-response filter, comprising the first signal after the correction has been applied, and a mix signal and wherein the output of the first programmable digital mixer is provided to the comparison-block via the first low-pass-filter; and
a second programmable digital mixer and a second low-pass-filter, wherein the second programmable digital mixer is configured to receive the response signal from the second input and the mix signal and wherein the output of the second programmable digital mixer is provided to the comparison-block via the second low-pass-filter,
wherein the at least one detector is configured to determine, at least, the feedback control signal at the first frequency and the feedback control signal at the second frequency by control of the mix signal by the controllable mixer arrangement.

In one or more embodiments, the feedback loop includes a first integrator configured to integrate the first output of the phase comparator and a second integrator configured to integrate the second output of the amplitude comparator; wherein the output of the first integrator and the second integrator provide the feedback control signal for the at least two taps of the finite-impulse-response filter such that the feedback loop is configured to drive the input to the first integrator and the second integrator to zero or within a threshold thereof.

In one or more embodiments, the feedback loop includes a coefficient determination element between the output of the first integrator and the finite-impulse-response filter wherein the coefficient determination element is configured to provide a number of coefficients for setting of the at least two taps of the finite-impulse-response filter.

In one or more embodiments, one or both of the first integrator and the second integrator are configurable to be initialized with an initial value when determining the feedback control signal at the second frequency, the initial value based on the feedback control signal at the first frequency determined when the feedback loop has driven the input to the first integrator and the second integrator to zero or within a threshold thereof; or wherein the gain of one or both of the first integrator and the second integrator is configurable. In one or more embodiments, the phase comparator is configured to determine and therefore output as the first output one of:

a cross product of the first signal of the output of the first low-pass-filter and the output of the second low-pass-filter or respective signals derived therefrom; and
a phase angle difference between the output of the first low-pass-filter and the output of the second low-pass-filter divided by the product of the amplitudes of the output of the first low-pass-filter and the output of the second low-pass-filter.

In one or more embodiments, the at least one detector is configured to provide the first signal; store the feedback control signal at the first frequency or the first frequency domain sample at a time when the feedback loop has caused the phase difference and the amplitude difference to be less than a predetermined threshold; and store the feedback control signal at the second frequency or the second frequency domain sample at a time when the feedback loop has caused the phase difference and the amplitude difference to be less than a further predetermined threshold.

In one or more embodiments, the at least one detector and interpolation block are configured to:
determine an interpolation between the first and second frequency domain samples or an inverse discrete Fourier transform of the at least first and second frequency domain samples.

In one or more embodiments, said at least one detector comprises a first detector and a second detector, wherein the first detector is configured to determine the first frequency domain sample and the second detector is configured to determine the second frequency domain sample in parallel, and wherein with the interpolation-block is configured to receive the frequency domain sample from the first detector and the frequency domain sample from the second detector.

According to a further aspect of the disclosure, we provide a combination of the detector device of the first aspect and a continuous-time, pipeline ADC, CT-P-ADC, wherein the CT-P-ADC comprises the digital filter, and the signal processing device comprises at least part of the CT-P-ADC, and the CT-P-ADC is configured to program the digital filter based on the calibration information.

In one or more embodiments, the CT-P-ADC comprises:

a CT-P-ADC input to receive an analogue signal,
a branch node configured to provide the analogue signal to a first path and a second path,
wherein the first path comprises at least a continuous time all-pass filter; CTAPF; a difference block having a first input configured to receive the output of the CTAPF and a second input, and configured to output a difference between signals at the first input and the second input; an amplifier configured to receive the output of the difference block and provide an output; a low-pass-filter configured to receive the output of the amplifier and provide an output; and a first ADC configured to receive the output of the low-pass-filter;
wherein the second path comprises a second ADC configured to receive the analogue signal via the branch node and the digital filter configured to receive the output of the second ADC;
wherein the CT-P-ADC comprises a summation block configured to provide an output of the CT-P-ADC based on a summation of the output of the first ADC from the first path and the output of the digital filter of the second path;
wherein the CT-P-ADC comprises a first DAC configured to receive the output of the second ADC and provide a digitised output to the second input of the difference block.

According to a second aspect of the disclosure we provide a method for a detector device for calibrating a digital filter to replicate a transfer function of a signal processing apparatus, the detector device comprising at least one detector for performing the method of:

receive, at a first input, a first signal;
receive, at a second input, a response signal comprising a response of the signal processing apparatus to the first signal;
making a comparison by a comparison-block comprising one or more both of a phase comparator and an amplitude comparator, of one or both of the phase and amplitude of the first signal and the response signal;
outputting, by the phase comparator, a first output indicative of a phase difference between the first signal after correction applied and the response signal;
outputting, by the amplitude comparator, a second output indicative of an amplitude difference between the first signal after correction applied and the response signal;
providing feedback, wherein a feedback loop including a finite-impulse-response filter, having at least two taps, coupled between the first input and the comparison block, is configured to, based on the output of the phase comparator and the output of the amplitude comparator, generate a feedback control signal to control the at least two taps to reduce the phase difference indicated by the first output and the amplitude difference indicated by the second output;
determining, at least, the feedback control signal at a first frequency and the feedback control signal at a second frequency, different to the first frequency, and
interpolating, by the interpolation-block, between the first frequency and the second frequency to determine calibration information for control of the transfer function of said digital filter.

In one or more examples, the first signal comprise one of:

white noise;
coloured noise;
a signal having frequency components at the at least first frequency and the second frequency;
a signal having frequency components at the first frequency at a first time and frequency components at the second frequency at a second, different time;
one or more sine waves; and
one or more square waves.

In one or more examples, the feedback control signal at the first frequency defines the at least two-taps of the finite-impulse-response filter that replicates the transfer function at the first frequency and the feedback control signal at the second frequency defines the at least two-taps of the finite-impulse-response filter that replicates the transfer function at the second frequency, and wherein the method includes determining the first frequency domain sample by determining a discrete Fourier transform of the feedback control signal at the first frequency and determining the second frequency domain sample by determining a discrete Fourier transform of the feedback control signal at the second frequency; and

applying, by the interpolation-block, an interpolation algorithm that determines, based on the first frequency domain sample and the second frequency domain sample and by interpolation, the calibration information, wherein the calibration information represents the transfer function of the signal processing apparatus at the first frequency and the second frequency and the transfer function interpolated therebetween.

In one or more examples, the method comprises determining the feedback control signal at the first frequency and the feedback control signal at the second frequency sequentially.

In one or more examples, the method includes determining an interpolation between the first and second frequency domain samples.

In one or more examples, the method includes determining an inverse discrete Fourier transform of the at least first and second frequency domain samples.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

## Brief Description of the Drawings

One or more embodiments will now be described by way of example only with reference to the accompanying drawings in which:

Figure 1 shows an example embodiment of a continuous-time pipelined analog to digital convertor;
Figure 2 shows the example embodiment of the continuous-time pipelined analog to digital convertor with a first signal, which may comprise a first test signal, applied thereto;
Figure 3 shows a first example embodiment of a detector device;
Figure 4 shows a second, more detailed embodiment of the detector device;
Figure 5 shows a flowchart illustrating an example method.

## Detailed Description

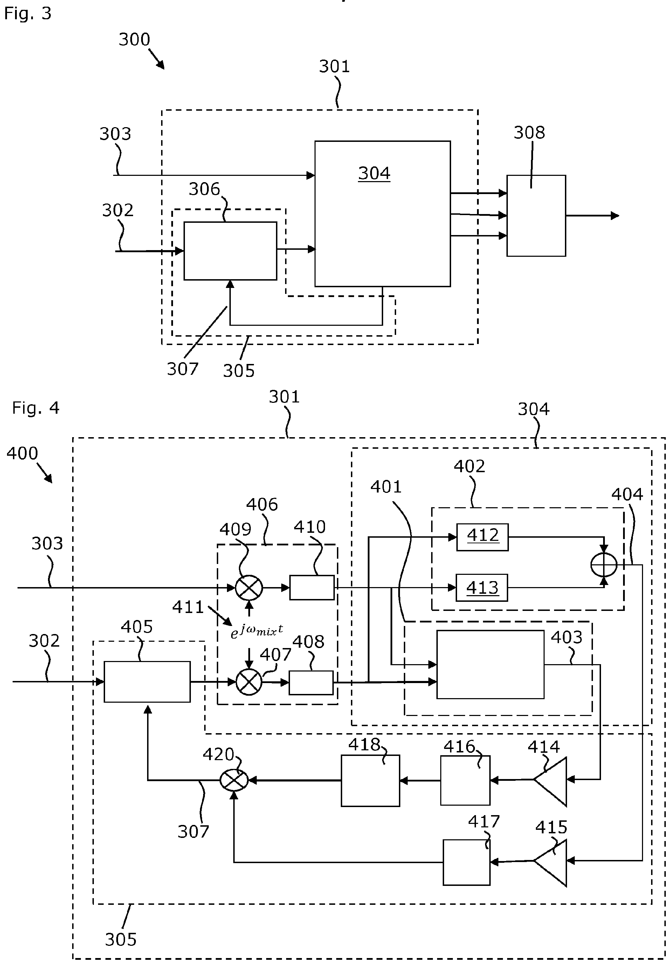

The present disclosure relates to a detector device which will be described with reference to figures 3 and 4. The detector device is for determining a transfer function of a signal processing device. The signal processing device comprises one or more digital and/or analogue components through which a signal is passed. In one or more examples, that will be described later, the detector device may be configured to derive calibration data to program a digital filter to replicate the transfer function of the signal processing device it has determined. The transfer function may comprise the phase shift and/or amplitude change induced by the one or more components of the signal processing device over a predetermined range of frequencies.

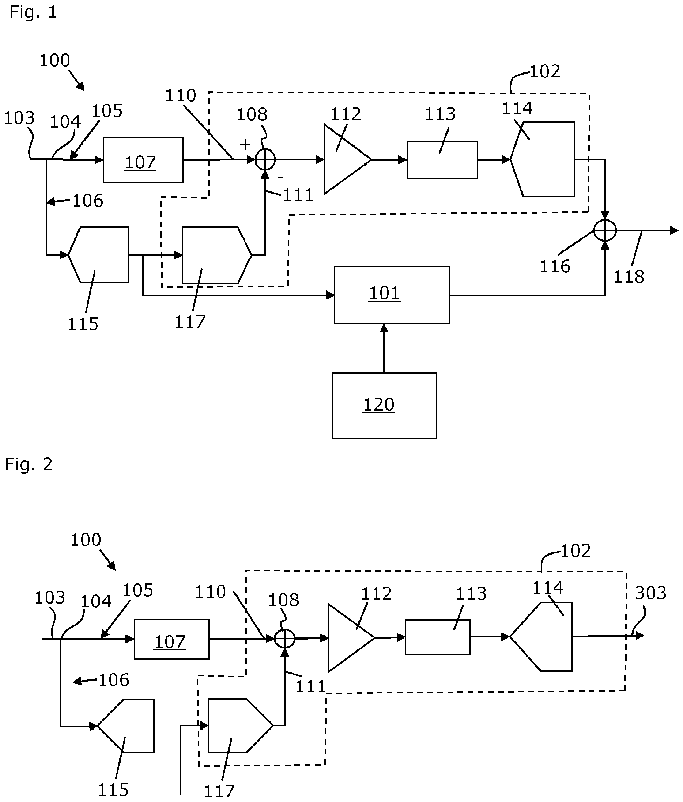

With reference to Figure 1, we describe a continuous-time pipelined analog to digital convertor, CT-P-ADC 100. The CT-P-ADC 100 comprises one example of many where the efficient replication of a transfer function by a digital filter is particularly advantageous. However, it should be understood that the present disclosure is not limited to the use of the detector device in combination with the continuous-time pipelined analog to digital convertor. Other examples combinations include use of the detector device with a multistage noise shaping (MASH) sigma-delta data converter.

Before we describe the detector device we will describe an example use-case with reference to the CT-P-ADC 100 of Figure 1.

In general, the CT-P-ADC 100 comprises a digital filter 101, and a signal processing apparatus 102 and the programming of the digital filter 101 is based on calibration information derived by the detector device described later.

The CT-P-ADC 100 comprises a CT-P-ADC input 103 configured to receive an analogue signal for conversion to a digital signal by the CT-P-ADC 100. The CT-P-ADC 100 comprises two branches and a branch node 104 is configured to split the analogue signal and provide it to a first path 105 and a second path 106.

The first path 105 includes a continuous time all-pass filter, CTAPF, 107. In other examples, the CTAPF 107 may be replaced by a delay element.

The first branch 105 further comprises a difference block 108 having a first input 110 configured to receive the output of the CTAPF 107 and a second input 111. The difference block 108 is configured to output a difference between signals at the first input 110 and the second input 111.

The first path 105 further comprises an amplifier 112 configured to receive the output of the difference block 108 and provide an amplified output. A low-pass-filter 113 is configured to receive the output of the amplifier 112 and provide a filtered output. It will be appreciated that the components of the first path 105 may be presented in a different order in other examples.

The first path 105 further comprises a first ADC 114, sometimes referred to as a "back-end ADC" or "fine ADC " by those skilled in the art, configured to receive the output of the low-pass-filter 113.

The second path 106 comprises a second ADC 115, sometimes referred to as a "coarse ADC" by those skilled in the art, configured to receive the analogue signal via the branch node 104. The digital output of the second ADC 115 is received by the digital filter 101. The digital filter 101 may be known as a reconstruction filter in the art of CT-P-ADCs.

The first path 105 and second path 106 merge at a summation block 116. As will be understood, the output of the summation block 116 comprises the output of the CT-P-ADC 100 and comprises a summation of the signal from the first and second paths 105, 106. Thus, the output comprises a summation of the output of the first ADC 114 of the first path 105 and the output of the digital filter 101 of the second path 106.

Further, the CT-P-ADC 100 comprises a first DAC 117 configured to receive the digital output of the second ADC 115 and provide an analogue output to the second input 111 of the difference block 108. Thus, the difference block 108 is configured to determine the difference between the analogue signal as delayed by the CTAPF 107 and the output of the second ADC 115, as converted to analogue again by the DAC 117. The delay provided by the CTAPF 107 is configured to match the delay introduced by the second ADC 115 and the first DAC 117.

The operation of the CT-P-ADC 100 will not be described here in detail as it is not relevant for the purpose of understanding the disclosure. However, as will be understood by those skilled in the art of CT-P-ADCs, the transfer function of the digital filter 101 should match, at least over a predetermined range of frequencies, the transfer function of the first DAC 117, the difference block 108, the amplifier 112, the low-pass filter 113 and the first ADC 114 (collectively, and more generally, referred to as the signal processing device 102).

Thus, when the transfer function is matched, the summation, at summation block 116, of the output of the first ADC 114 and output of the filter 101 results in the cancellation of the quantization noise of the second ADC 115 in the final output at 118.

It will be appreciated that the CT-P-ADC 100 may comprise a plurality of stages in the first path and therefore the signal processing device 102 may comprise the first DAC 117, the difference block 108, the amplifier 112, the low-pass filter 113 and the first ADC 114 and then a second stage in series with a further first DAC, difference block, amplifier, low-pass filter and first ADC. In other examples the detector device may be configured to determine the transfer function of all of the stages collectively or each stage separately. Thus, in some examples there may be provided a digital filter in the second path for each stage which will be in need of programming by the detector device described later.

Returning to the embodiment as shown in figure 1, the detector device 120 may be used to program the digital filter 101. Although not shown in figure 1, the detector device 120 is coupled to the signal processing device 102 in order to measure the transfer function over a predetermined range of frequencies to determine calibration data for use in programming the digital filter 101. It will be appreciated that the calibration data may define the transfer function of the signal processing device 102 or an approximation thereof over a predetermined range of frequencies. Alternatively, the calibration data may take the form of a plurality of parameters, such as tap values, for programming the digital filter 101. Whichever form the calibration data takes, it may be suitable for programming the digital filter 101 to filter the signal in the second path 106 in a way that replicates the transfer function of the signal processing device 102 to within a predetermined accuracy.

In the one or more of the present examples we disclose a detector device to generate calibration data for the digital filter 101 which can be implemented with sufficiently low complexity and power while maintaining enough accuracy to guarantee the system performance. In one or more examples, the CT-P-ADC may be used for a radar application which, by use of the detector device 120, allows for quick re-calibration in between consecutive radar cycles.

In one or more examples, the combination of the CT-P-ADC 100 and the detector device 120 may be configured to operate in a calibration-information-determination mode, wherein a first signal, which may be a test signal, is applied to signal processing device 102 and the detector device 120 is configured to determine the calibration information. The digital filter 101 may then be programmed. In one or more examples, the combination may also operate in a normal mode in which the CT-P-ADC 100 is provided with an analogue input signal and is configured to provide a digital signal representing said analogue input signal at the output 118 and the detector device 120 is inactive.

Figure 2 shows part of the CT-P-ADC 100 and provides an example in which the test signal is applied. The same reference numerals have been used for like parts. Thus, when operating in the calibration-information-determination mode, the test signal is applied to the input of the first DAC 117. Therefore, this disclosure proposes a foreground calibration where no analogue signal is applied during the calibration-information-determination mode. In the present example, the test signal is applied to the first DAC 117 that is used as part of the CT-P-ADC 100 but, in other examples, the test signal may be applied via an auxiliary DAC (not shown) that outputs an analogue version of the test signal to the difference block 108 or the amplifier 112.

The first signal or "test signal" may comprise one of: white noise; coloured noise; and one or more sine waves. In one or more examples, the test signal may be set to one of a plurality of different predetermined frequencies. The calibration information may then be determined. Then, setting the test signal to a different one of the plurality of frequencies enables the detector device to characterise the transfer function at the different frequency or frequencies. In other examples, like the one described later, the test signal may be unaltered during operation of the detector device 100 in the calibration-information-determination mode and other means may be provided to adjust the frequency evaluated by the detector device. In one or more examples, the ADC 115 may be configured to create wideband noise which is used as a test signal, even when the original input to the ADC 115 was narrowband.

As an alternative to applying a test signal at the first DAC 117, a sine wave may be applied to the CT-P-ADC input 103. In such an example the output of the second ADC 115 and the output of the first ADC 114 are provided to the detector device 120 to determine the calibration information. In such an example, the quantization noise of the second ADC 115 is used to characterise the response of the DAC 117, amplifier 112, low-pass filter 113 and first ADC 114 path. This example may be used as a background calibration system i.e. while the CT-P-ADC 100 is in its normal mode. Accordingly, the calibration-information-determination mode may not be needed in such an example.

Figure 3 shows an example of the detector device 300. Figure 4 shows a more detailed example of the detector device 400. The following description makes reference to both embodiments. The detector device comprises, in the present example, one detector 301 that is configured to operate sequentially to determine the transfer function at a plurality of predetermined frequencies. In other examples, the detector device 300 comprises a plurality of detectors each configured to determine the transfer function at a different one of the plurality of predetermined frequencies in parallel.

The detector 301 comprises a first input 302 configured to receive a first signal. A second input 303 of the detector 301 is configured to receive a response signal comprising the response of the signal processing apparatus 102 (or other components) to the first signal, which may be applied via the first DAC 117 as described above.

The detector 301 further comprises a comparison-block 304 comprising one or both of a phase comparator 401 and an amplitude comparator 402 (shown in the example of figure 4 but not shown in Figure 3).

The phase comparator 401 is configured to provide a first output (at output 403 in figure 4) indicative of a phase difference between the first signal and the response signal. The amplitude comparator 402 is configured to provide a second output (at output 404 in figure 4) indicative of an amplitude difference between the first signal and the response signal.

The detector 301 further comprises a feedback loop configured to modify, by signal modification block 306 (in the example of figure 3) or finite-impulse-response filter 405 (in the example of figure 4) the test signal provided to the first input 302 to reduce any phase difference and/or amplitude difference detected by the comparison-block 304 and, in particular, the phase comparator 401 and the amplitude comparator 402 thereof. The configuration of the signal modification block 306 or finite-impulse-response filter 405 is thereby indicative of the transfer function of the signal processing device 102 at a particular frequency.

The signal modification block 306 (in the example of figure 3) or finite-impulse-response filter 405 (in the example of figure 4) are coupled between the first input 302 and the comparison block 304, or comparators 401+402.

The feedback loop 305 is configured to, based on the output of the phase comparator 401 and the output of the amplitude comparator 402, provide a feedback control signal shown at 307 to control the signal modification block 306 or the two taps of the FIR filter 405 to reduce the phase difference indicated by the first output 403 and the amplitude difference indicated by the second output 404.

The finite-impulse-response filter 405 in the present example has two taps. However, in other examples it may have at least two taps or at least three taps or one tap.

The detector 301 further comprises an interpolation-block 308 (only shown in Figure 3), which may provide an algorithm that interpolates to determine the transfer function over a range of frequencies based on the feedback control signals at at least two different frequencies.

Thus, the at least one detector 301 is configured to determine, at least, the feedback control signal at a first frequency and the feedback control signal at a second frequency, different to the first frequency. In other examples, the feedback control signals are determined at further frequencies, such as at least three different frequencies or at least four.

A frequency selection block 406 (not shown in figure 3) is provided for control of the frequency of the first signal to provide the first frequency and the second frequency. The frequency selection block may be provided at the input to the comparison-block 304 and, in particular, after a correction has been applied by the signal modification block 306 (in the example of figure 3) or finite-impulse-response filter 405 (in the example of figure 4). In other examples, the frequency of the first signal may be controlled at other points, such as at the first input 302 or provision to the signal processing apparatus.

The interpolation-block 308 is configured to interpolate the feedback control signals at least between the first frequency and the second frequency. Thus, the interpolation-block takes the feedback control signals that represent the transfer function at discrete frequencies and, by interpolation, may generate information indicative of a continuous transfer function over a range of frequencies. The transfer function that is generated or, put another way, the interpolated feedback control signals, are used to determine calibration information for control of the transfer function of said digital filter 101. The interpolation, in general, is based on an inverse Fourier transform of a function of at least the feedback control signal at the first frequency and the feedback control signal at the second frequency.

Thus, after the interpolation, the calibration information may represent a continuous transfer function at least between at least the first frequency and the second frequency that replicates the transfer function of the signal processing apparatus.

Looking at the more detailed embodiment of Figure 4, we will now describe how the detector 301 determines the feedback control signals at the different first and second frequencies.

The detector device 400 includes a controllable mixer arrangement 406 comprising a first programmable digital mixer 407 and a first low-pass-filter 408 that provides the input for the phase comparator 401 and the amplitude comparator 402. The controllable mixer arrangement 406 further comprises a second programmable digital mixer 409 and a second low-pass-filter 410 that provides the input for the phase comparator 401 and the amplitude comparator 402.

The first programmable digital mixer 407 is configured to receive the output of the finite-impulse-response filter 405 and a mix signal 411 and wherein the output of the first programmable digital mixer 407 is provided to the phase comparator 401 and the amplitude comparator 402 via the first low-pass-filter 408. The second programmable digital mixer 409 is configured to receive the response signal from the second input 303 and the mix signal 411 and wherein the output of the second programmable digital mixer 409 is provided to the phase comparator 401 and the amplitude comparator 402 via the second low-pass-filter 410.

In this example embodiment, control of the mix signal 411 ($e^{j\omega_{mix}t}$) generated by the controllable mixer arrangement 406 provides for determination of the feedback control signals at the different first and second frequency. In one or more examples, the first programmable digital mixer 407 and the second programmable digital mixer 409 are provided by a coordinate rotation digital computer, CORDIC. In other examples, the same function can be provided without use of components that process complex numbers by implementing two parallel paths having 90 degrees phase shifted mixing waveforms, where one path represents the real and the other represents the imaginary path.

In the present examples, the first signal comprises a test signal. However, in other examples, as mentioned briefly above, the calibration information may be determined during normal use. Thus, the signal processing device may be receiving its normal, in-use, signals and the calibration information may be determined. It will be appreciated however that the normal signal, in-use, signals must have frequency components at the first frequency and the second frequency. Alternatively, the normal signal, in-use, signal must comprise a signal having frequency components at the at least first frequency at a first time and frequency components at the second frequency at a second, different time such that the feedback control signals can be determined sequentially.

Thus, the calibration information may be determined using a test signal, normal in-use signals, or a test signal added on top of the normal in-use signals.

The operation of the amplitude comparator 402 is relatively straightforward - the absolute values of both outputs from the controllable mixer arrangement 406 are determined by blocks 412 and 413 which are subtracted and provided at output 404.

The phase comparator 401 may operate based on a cross product of the first signal and the response signal or respective signals derived therefrom.

The complex cross product of signals A and B, representing the output from the first and second low-pass filters 408, 410 in Figure 4 respectively, is given as follows:

$$A \times B = |A||B|sin(\phi) = real(A)imag(B) - real(B)imag(A)$$

In some examples, only one of the two terms (*real(A)imag(B)* or *real(B)imag(A)*) of the cross product is determined by the phase comparator, but this may lead to slower and less stable convergence.

The equation shows two equivalent ways of calculating the complex cross product. In the present example, the cross product is determined by the calculation of (*real(A)imag(B) - real(B)imag(A)*) by the phase comparator 401.

The middle part of the equation shows that the complex cross product can be interpreted as the multiplication of the absolute values and the sine of the phase difference between both inputs. Using the small angle approximation; sin(phi)=phi; we find that the complex cross product is directly proportional to the phase difference between its inputs. By dividing out the absolute values, the amplitude and phase comparators 401, 402 may operate independently, leading to fast convergence. The absolute values are already available since they are needed for the amplitude comparator 402. In one or more examples, the division by the absolute values need not to be performed very accurately, since it only influences the loop-gain of the feedback loop 305.

$$\frac{A \times B}{|A| \cdot |B|} = sin(\phi)$$

The first output 403 and the second output 404 are, in this example, each received by a respective digital multiplier/scaler 414, 415. However, in other examples, the digital multipliers/scalers 414, 415 may not be required. It will be appreciated that as everything in block 400 may be digital, the digital multipliers/scalers 414 and 415 may be provided to set the feedback loop gain.

The feedback loop 305 further comprises a first integrator 416 configured to integrate the first output 403 of the phase comparator 401. The feedback loop 305 may comprise a second integrator 417 configured to integrate the second output 404 of the amplitude comparator 402. In one or more examples, the integrator(s) are configured to be initialised to integrate for each frequency set by the controllable mixer arrangement 406 and, once the feedback loop 305 provides a sufficient convergence, the feedback control signal(s) are determined and then the integrator(s) are reset for the next frequency set by the controllable mixer arrangement 406.

In one or more examples, not shown in the figures, a further component may be provided between output 403 and the integrator 416, such as before digital multiplier/scaler 414. The further component may be configured to divide the output 403 by a multiplication of the outputs from blocks 412 and 413. This may serve to improve the independent detection of gain and phase, as suggested above.

The first integrator 416 may be configured to output a measure of the phase difference in terms of a number of samples, termed D. The feedback loop 305 may comprise a coefficient determination element 418 between the output of the first integrator 416 and the finite-impulse-response filter 405 (or, more generally, the signal modification block 306). The coefficient determination element 418 is configured to provide two coefficients wherein the first coefficient comprises 1-D and the second coefficient comprises D, which may be configured to correspond to the settings of the two taps of the finite-impulse-response filter 405. As will be understood the digital FIR filter 405 with coefficients [(1-D), D] will implement a delay of D samples.

The second integrator 417 may be configured to provide the average amplitude difference over at least a predetermined recent time period, which may correspond to the period the controllable mixer arrangement 406 provides the first frequency and, when the second frequency is provided, the period the controllable mixer arrangement 406 provides the second frequency and so on. The output of the second integrator 417 and the coefficients from the coefficient determination element 418 may comprise the feedback control signal and are fed to the finite-impulse-response filter 405. However, in the present example, the detector device 400 includes a digital multiplier 420. The digital multiplier 420 scales both of the coefficients provided by the coefficient determination element 418.

It will be appreciated that the integrators 416, 417 are configured to act as digital accumulators. In effect, they may be configured to determine an output equal to their input + the previous output. As will be familiar to those skilled in the art, this is can be achieved with a summing element and a memory element. It will also be appreciated that as the integrators 416, 417 are provided with a negative feedback loop, they will converge and therefore allow for the derivation of the feedback control signal.

It will be appreciated that in a steady state (after convergence when the finite-impulse-response filter 405 has been set with appropriate feedback control signals) the average value of the input of the integrators 416, 417 equals zero. Thus, the integrators 420 and 405 find the amplitude and phase correction that make the outputs of the amplitude and phase low-pass filters 408 and 410 equal. For the phase correction, the embodiment uses a time shift (by means of the two taps of the FIR filter 405). Since we look at a small frequency part of the spectrum, the phase correction can be approximated by a time correction. It will be appreciated that other operational calculations may be performed, such as to determine the phase delay rather than the time delay.

The shape of the FIR filter 405 is defined once D is found. It will generally provide a low-pass filter with the correct phase/delay at the frequency of interest. For the FIR filter 405 to also have the correct amplitude response at the frequency of interest a scaling factor is applied, wherein this scaling factor is provided by the output of block 417. The scaling factor, in the present examples, does not affect the phase response and shape of the FIR filter 405.

In use, the feedback loop 305 is configured to make output of the second and first low-pass filters 410 and 408 equal. The amplitude and phase comparators 401, 402 are designed to output "zero" once this is the case.

If, for example, the output of the second low-pass filter 410 is larger than the output of first low-pass filter 408, the amplitude comparator 402 will give a positive value which will be summed to the previous output of the integrator 417. Consequently the output of integrator 417 will go up and this will increase the value of the coefficients provided to the FIR filter 405, causing the output of the first low-pass filters 408 to go up. Thus, during convergence, the outputs of the second and first low-pass filters 410 and 408 become equal and therefore the output of the amplitude and phase comparators 401, 402 becomes zero, causing the output of the integrators 416, 417 to remain constant, indicating a convergence.

Once the feedback loop 305 is determined to have converged such that the inputs to the integrators 416, 417 are driven to within a predetermined value of zero (indicating the modification made by the signal modification block or FIR filter matches the transfer function of the signal processing device) or the output of the integrators 416, 417 remains constant, the feedback control signal at 307 or the values of the taps of the FIR filter 405 is stored as the feedback control signal for the first frequency.

In one or more examples, the feedback control signal at 307 or the values of the taps of the FIR filter are translated such that they represent the transfer function at the first frequency. In particular, the FIR filter 405 may have any shape (usually lowpass) and it applies only the right correction at the frequency of interest, that is the first frequency (and later the second frequency and so on). To translate this to the frequency domain "sample" such that it can represent the signal processing apparatus 102, the detector device 400 may be configured to calculate the transfer function of FIR filter 405 at the first frequency. Since this impulse response has only two taps and we are only interested in only one specific frequency, this calculation can be performed very efficiently using a DFT (discrete fourier transform). The result of the DFT is the frequency domain sample of the transfer function of the signal processing apparatus 102. Accordingly, in general terms, the detector or detector device is configured to determine a Fourier transform of the feedback control signal(s) at the first frequency to determine a frequency domain sample at the first frequency.

Thus, the detector device 400, by taking the DFT, determines the transfer function of the FIR filter 405 at the first frequency at the time the feedback loop 305 has converged. Thus, the coefficients of the FIR filter 405, after convergence, are translated via a DFT to an amplitude and phase transfer for the first frequency set by the mix signal 411, $\omega_{mix}$.

In the description so far, the FIR filter 405 is disclosed as having two (non-zero) taps. However, in other examples, it may have at least two taps or three taps. For example, with two (non-zero) taps we can make any response we want if we only are focussed on one (e.g. first) frequency at the time. In some examples, D may be larger than 1. If D is between 0 and 1 the output of coefficient determination element 418 would be [1-D,D] as mentioned before. If D is between 2 and 1 the output of the coefficient determination element 418 is [(2-D),(D-1)] plus an indicator that D is between 2 and 1 and therefore a one cycle delay needs to be implemented before or after the FIR filter 405. In this case, the implementation of FIR filter 405 including the additional delay can be interpreted as a three tap filter with the first tap being equal to zero: as follows - gain_scaling*[0,(2-D),(D-1)]. If D is between 3 and 2 the output of coefficient determination element 418 would be [(3-D),(D-2)], plus an indicator that D is between 3 and 2 and therefore a two cycle delay need to be implemented before or after the FIR filter 405.

Returning to the present embodiment, the controllable mixer arrangement 406 then controls the mix signal 411 to provide the response to the test signal from 303 and the test signal from first input 302 at the second frequency. The feedback loop 305 then again is allowed to converge such that the inputs to the integrators 416, 417 are driven to within a predetermined value of zero, and the feedback control signal at 307 or at the taps of the FIR filter is stored as the feedback control signal for the second frequency.

As previously, the feedback control signal at 307 or the values of the taps of the FIR filter are translated such that they represent the transfer function at the second frequency. To translate this to the frequency domain "sample" such that it can represent the signal processing apparatus 102, the detector device 400 may be configured to calculate the transfer function of FIR filter 405 at the second frequency. This calculation can be performed efficiently using a DFT. The result of the DFT is the frequency domain sample of the transfer function of the signal processing apparatus 102. Again, in general terms, the detector or detector device is configured to determine a Fourier transform of the feedback control signal(s) at the second frequency to determine a frequency domain sample at the second frequency.

Thus, the detector device 400, by taking the DFT, determines the transfer function of the FIR filter 405 at the second frequency at the time the feedback loop 305 has converged. Thus, the coefficients of the FIR filter 405, after convergence, are translated via a DFT to an amplitude and phase transfer for the second frequency set by the mix signal 411, $\omega_{mix}$.

The interpolation-block 308 (only shown in Figure 3) is configured to apply an interpolation algorithm to determine the calibration information that represents the transfer function for the digital filter 101. The interpolation algorithm operates on the frequency domain samples taken at the first frequency and the second frequency and any other frequencies.

In general, once sufficient frequency domain samples have been found. The interpolation-block 308 provides the interpolation algorithm. The interpolation algorithm is described in US 10, 447, 523 B2 but will be summarised here. The interpolation algorithm may be viewed as an interpolation of the frequency domain with complex exponentials as interpolation/basis functions. As any digital filter has a periodic transfer function, it is logical to use periodic functions as basis for the interpolation. The problem to be solved is to find the scaling coefficients for the interpolation functions, wherein these scaling coefficients correspond to the coefficients of the digital filter 101. Below, the relation between the frequency domain samples (termed Vector Xk), the impulse response of the final reconstruction filter (termed Vector xn) and the interpolation functions is shown. As the digital filter 101 may be a FIR filter, the impulse response is equal to its coefficients. N is equal to the length of xn and Fmix is a vector consisting of the frequencies of the frequency domain samples. Xk, Fmix and xn need to be of the same length. The vector with the frequencies is referred to as Fmix because it also corresponds to the mixing frequency $\omega_{mix}$ within the detector 400 when a frequency domain sample is found.

$$X_k = \sum_{n=0}^{N-1} x_n \cdot e^{-j2\pi\left(\frac{F_{mix}(n)}{F_s}\right)k}$$

The relation can also be written explicitly in matrix form.

$$X_k = [x(0), x(1), x(2). \ldots, x(N-1)] \cdot exp(-j2\pi\frac{1}{F_s}\left\{\begin{array}{l} [0 \cdot F_{mix}(0), 1 \cdot F_{mix}(0). \ldots, (N-1) \cdot F_{mix}(0)]; \\ [0 \cdot F_{mix}(1), 1 \cdot F_{mix}(1). \ldots, (N-1) \cdot F_{mix}(1)]; \\ \vdots \quad \vdots \quad \vdots \quad \vdots \\ [0 \cdot F_{mix}(N-1), 1 \cdot F_{mix}(N-1). \ldots, (N-1) \cdot F_{mix}(N-1)] \end{array}\right\})$$

Where Xk represents the transfer function of the analog signal processing system 102 at the frequency domain samples, at the frequency locations given by the vector *Fmix.*

$$X_k = [H\{Fmix(0)\}, H\{Fmix(1)\}, H\{Fmix(2)\}. \ldots, H\{Fmix(N-1)\}]$$

More compactly:

$$X_k = x \cdot A$$

Where A is a matrix is formed of the interpolation basis functions.
This relation is then used to find the transfer function for the digital filter 101:

$$x = X_k \cdot A^{-1}$$

Note that A⁻¹ only depends on the frequencies where the frequency domain samples are taken. Consequently, once the frequencies are known, any update to the digital filter 101 only requires a single matrix multiplication. The digital filter 101 may have a linear relation with the frequency domain samples.
In a further example, it can be noted that when the Fmix is defined as follows:

$$Fmix = \frac{F_s}{N} \cdot [0, 1, 2, 3. \ldots, N-1]$$

The interpolation algorithm reduces to an Inverse-Discrete-Fourier-Transform(IDFT).
To explain further, the definition of the Discrete-Fourier-Transform(DFT) is shown below.

$$X_k = \sum_{n=0}^{N-1} x_n \cdot e^{-j2\pi\left(\frac{n}{N}\right)k}$$

When using equidistant frequency domain samples:

$$\frac{n}{N} = \frac{F_{mix}(n)}{F_s}$$

Consequently, the IDFT can be viewed as a special case of the proposed interpolation algorithm. However, the previous example of the interpolation algorithm provides greater flexibility in the location of the frequency domain samples. Though, the impact of a choice of the vector Fmix on the quality of the interpolation has to be taken into account.

The interpolation algorithm results in a digital filter 101 that matches perfectly at predetermined locations and interpolates in between.

It will be appreciated that, in other embodiments, the interpolation algorithm may take different forms to map the frequency domain samples to a digital filter 101, such as a least squares method that puts less emphasis on the matching at the predetermined locations but can reach improved matching outside of the predetermined locations.

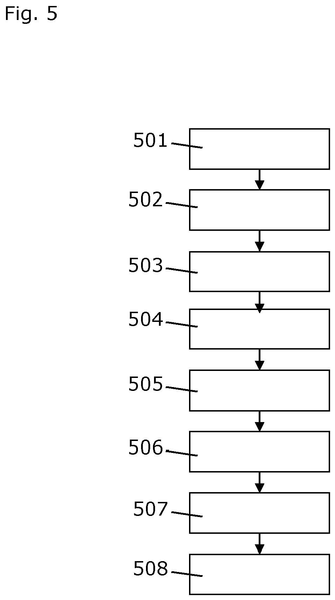

Figure 5 shows an example method for performing by a detector device for calibrating a digital filter to replicate a transfer function of a signal processing apparatus, the detector device comprising at least one detector for performing the method of:

receive 501, at a first input, a first signal;
receive 502, at a second input, a response signal comprising a response of the signal processing apparatus to the first signal;
making 503 a comparison by a comparison-block comprising one or more both of a phase comparator and an amplitude comparator, of one or both of the phase and amplitude of the first signal and the response signal;
outputting 504, by the phase comparator, a first output indicative of a phase difference between the first signal and the response signal;
outputting 505, by the amplitude comparator, a second output indicative of an amplitude difference between the first signal and the response signal;
providing feedback 506, wherein a feedback loop including a finite-impulse-response filter, having at least two taps, coupled between the first input and the comparison block, is configured to, based on the output of the phase comparator and the output of the amplitude comparator, generate a feedback control signal to control the at least two taps to reduce the phase difference indicated by the first output and the amplitude difference indicated by the second output;
determining 507, at least, the feedback control signal at a first frequency and the feedback control signal at a second frequency, different to the first frequency, and
interpolating 508, by the interpolation-block, between the first frequency and the second frequency to determine calibration information for control of the transfer function of said digital filter.

In a further example, the CT-P-ADC 100 and the detector device 100 are provided in combination and may comprise part of a radar device.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A detector device for calibrating a digital filter to replicate a transfer function of a signal processing apparatus, the detector device comprising at least one detector comprising:

   a first input configured to receive a first signal;
   a second input configured to receive a response signal comprising a response of the signal processing apparatus to the first signal;
   a controllable finite-impulse-response, FIR, filter;
   a comparison-block comprising one or both of a phase comparator and an amplitude comparator, wherein the phase comparator is configured to provide a first output indicative of a phase difference between the first signal, after a correction has been applied by the controllable FIR filter, and the response signal and the amplitude comparator is configured to provide a second output indicative of an amplitude difference between the first signal, after a correction has been applied by the controllable FIR filter, and the response signal;
   a feedback loop including the controllable FIR filter, wherein the controllable FIR filter has at least two taps and is coupled between the first input and the comparison block and is configured to selectively apply the correction to the first signal, and wherein the feedback loop is configured to, based on the output of the phase comparator and the output of the amplitude comparator, provide a feedback control signal to control the at least two taps to reduce the phase difference indicated by the first output and the amplitude difference indicated by the second output; and
   an interpolation-block;
   wherein the at least one detector is configured to determine, at least, the feedback control signal at a first frequency and the feedback control signal at a second frequency, different to the first frequency, and wherein the interpolation-block is configured to interpolate at least between the first frequency and the second frequency to determine calibration information for programming of the transfer function of said digital filter based on at least a first frequency domain sample derived from the feedback control signal at the first frequency and a second frequency domain sample derived from the feedback control signal at the second frequency.

2. The detector device of claim 1, wherein the first signal comprise one of:

   white noise;
   coloured noise;
   a signal having frequency components at the at least first frequency and the second frequency;
   a signal having frequency components at the first frequency at a first time and frequency components at the second frequency at a second, different time;
   one or more sine waves; and
   one or more square waves.

3. The detector device of claim 1 or claim 2, wherein the feedback control signal at the first frequency defines the at least two-taps of the finite-impulse-response filter that replicates the transfer function at the first frequency and the feedback control signal at the second frequency defines the at least two-taps of the finite-impulse-response filter that replicates the transfer function at the second frequency, and wherein the detector is configured to determine the first frequency domain sample by determining a discrete Fourier transform of the feedback control signal at the first frequency and is configured to determine the second frequency domain sample by determining a discrete Fourier transform of the feedback control signal at the second frequency; and

the interpolation-block is configured to apply an interpolation algorithm that determines, based on the first frequency domain sample and the second frequency domain sample and by interpolation, the calibration information, wherein the calibration information represents the transfer function of the signal processing apparatus at the first frequency and the second frequency and the transfer function interpolated therebetween.

4. The detector device of any preceding claim, wherein the detector device is configured to determine the feedback control signal at the first frequency and the feedback control signal at the second frequency sequentially.

5. The detector device of any preceding claim, wherein the at least one detector includes a controllable mixer arrangement comprising:

a first programmable digital mixer and a first low-pass-filter, wherein the first programmable digital mixer is configured to receive the output of the finite-impulse-response filter, comprising the first signal after the correction has been applied, and a mix signal and wherein the output of the first programmable digital mixer is provided to the comparison-block via the first low-pass-filter; and

a second programmable digital mixer and a second low-pass-filter, wherein the second programmable digital mixer is configured to receive the response signal from the second input and the mix signal and wherein the output of the second programmable digital mixer is provided to the comparison-block via the second low-pass-filter,

wherein the at least one detector is configured to determine, at least, the feedback control signal at the first frequency and the feedback control signal at the second frequency by control of the mix signal by the controllable mixer arrangement.

6. The detector device of any preceding claim, wherein the feedback loop includes a first integrator configured to integrate the first output of the phase comparator and a second integrator configured to integrate the second output of the amplitude comparator; wherein the output of the first integrator and the second integrator provide the feedback control signal for the at least two taps of the finite-impulse-response filter such that the feedback loop is configured to drive the input to the first integrator and the second integrator to zero or within a threshold thereof.

7. The detector device of claim 6 wherein the feedback loop includes a coefficient determination element between the output of the first integrator and the finite-impulse-response filter wherein the coefficient determination element is configured to provide a number of coefficients for setting of the at least two taps of the finite-impulse-response filter.

8. The detector device of claim 6 or claim 7, wherein one or both of the first integrator and the second integrator are configurable to be initialized with an initial value when determining the feedback control signal at the second frequency, the initial value based on the feedback control signal at the first frequency determined when the feedback loop has driven the input to the first integrator and the second integrator to zero or within a threshold thereof; or wherein the gain of one or both of the first integrator and the second integrator is configurable.

9. The detector device of claim 5, wherein the phase comparator is configured to determine and therefore output as the first output one of:

a cross product of the first signal of the output of the first low-pass-filter and the output of the second low-pass-filter or respective signals derived therefrom; and

a phase angle difference between the output of the first low-pass-filter and the output of the second low-pass-filter divided by the product of the amplitudes of the output of the first low-pass-filter and the output of the second low-pass-filter.

10. The detector device of any preceding claim, wherein the at least one detector is configured to provide the first signal; store the feedback control signal at the first frequency or the first frequency domain sample at a time when the feedback loop has caused the phase difference and the amplitude difference to be less than a predetermined threshold; and store the feedback control signal at the second frequency or the second frequency domain sample at a time when the feedback loop has caused the phase difference and the amplitude difference to be less than a further predetermined threshold.

11. The detector device of any preceding claim, wherein the at least one detector and interpolation block are configured to: determine an interpolation between the first and second frequency domain samples or an inverse discrete Fourier transform of the at least first and second frequency domain samples.

12. The detector device of any preceding claim, wherein said at least one detector comprises a first detector and a second detector, wherein the first detector is configured to determine the first frequency domain sample and the second detector is configured to determine the second frequency domain sample in parallel, and wherein with the interpolation-block is configured to receive the frequency domain sample from the first detector and the frequency domain sample from the second detector.

13. A combination of the detector device of any preceding claim and a continuous-time, pipeline ADC, CT-P-ADC, wherein the CT-P-ADC comprises the digital filter, and the signal processing device comprises at least part of the CT-P-ADC, and the CT-P-ADC is configured to program the digital filter based on the calibration information.

14. The combination of claim 13, wherein the CT-P-ADC comprises:

a CT-P-ADC input to receive an analogue signal,
a branch node configured to provide the analogue signal to a first path and a second path,
wherein the first path comprises at least a continuous time all-pass filter; CTAPF; a difference block having a first input configured to receive the output of the CTAPF and a second input, and configured to output a difference between signals at the first input and the second input; an amplifier configured to receive the output of the difference block and provide an output; a low-pass-filter configured to receive the output of the amplifier and provide an output; and a first ADC configured to receive the output of the low-pass-filter;
wherein the second path comprises a second ADC configured to receive the analogue signal via the branch node and the digital filter configured to receive the output of the second ADC;
wherein the CT-P-ADC comprises a summation block configured to provide an output of the CT-P-ADC based on a summation of the output of the first ADC from the first path and the output of the digital filter of the second path;
wherein the CT-P-ADC comprises a first DAC configured to receive the output of the second ADC and provide a digitised output to the second input of the difference block.

15. A method for a detector device for calibrating a digital filter to replicate a transfer function of a signal processing apparatus, the detector device comprising at least one detector for performing the method of:

receive, at a first input, a first signal;
receive, at a second input, a response signal comprising a response of the signal processing apparatus to the first signal;
making a comparison by a comparison-block comprising one or more both of a phase comparator and an amplitude comparator, of one or both of the phase and amplitude of the first signal and the response signal;
outputting, by the phase comparator, a first output indicative of a phase difference between the first signal after correction applied and the response signal;
outputting, by the amplitude comparator, a second output indicative of an amplitude difference between the first signal after correction applied and the response signal;
providing feedback, wherein a feedback loop including a finite-impulse-response filter, having at least two taps, coupled between the first input and the comparison block, is configured to, based on the output of the phase comparator and the output of the amplitude comparator, generate a feedback control signal to control the at least two taps to reduce the phase difference indicated by the first output and the amplitude difference indicated by the second output;
determining, at least, the feedback control signal at a first frequency and the feedback control signal at a second frequency, different to the first frequency, and
interpolating, by the interpolation-block, between the first frequency and the second frequency to determine calibration information for control of the transfer function of said digital filter.

Fig. 1

Fig. 2

Fig. 3

Fig. 4

$e^{j\omega_{mix}t}$

Fig. 5

Europäisches
Patentamt

European
Patent Office

Office européen
des brevets

# EUROPEAN SEARCH REPORT

Application Number

EP 23 15 6114

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KSHIRSAGAR PARAG ET AL: "Implementation and Evaluation of Online System Identification of Electromechanical Systems Using Adaptive Filters", IEEE TRANSACTIONS ON INDUSTRY APPLICATIONS, IEEE SERVICE CENTER, PISCATAWAY, NJ, US, vol. 52, no. 3, 1 May 2016 (2016-05-01), pages 2306-2314, XP011610291, ISSN: 0093-9994, DOI: 10.1109/TIA.2016.2515994 [retrieved on 2016-05-18] * Section II; figures 1-3 * | 1-15 | INV. H03M1/10 ADD. H03M1/14 H03M3/00 |
| X | SUDHARSAN KANAGARAJ ET AL: "An online fully-digital calibration of leakage noise in MASH continuous time modulators", CIRCUITS AND SYSTEMS (ISCAS), 2011 IEEE INTERNATIONAL SYMPOSIUM ON, IEEE, 15 May 2011 (2011-05-15), pages 1632-1635, XP031997953, DOI: 10.1109/ISCAS.2011.5937892 ISBN: 978-1-4244-9473-6 * Section IV; figures 1,2 * | 1,13-15 | |

-----

-/--

| | | | TECHNICAL FIELDS SEARCHED (IPC) |
|---|---|---|---|
| | | | H03M |

The present search report has been drawn up for all claims

| Place of search | Date of completion of the search | Examiner |
|---|---|---|
| The Hague | 30 August 2023 | Jesus, Paulo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................................

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

**EP 23 15 6114**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Anonymous: "Frequency response and impulse response of black box – Signal Processing Stack Exchange", , 25 October 2015 (2015-10-25), pages 1-2, XP093076448, Retrieved from the Internet: URL:https://dsp.stackexchange.com/questions/26647/frequency-response-and-impulse-response-of-black-box [retrieved on 2023-08-26] * page 1 – page 2 * ----- | 1-15 | |
| A | Anonymous: "How to fit built in filter functions – MATLAB Answers – MATLAB Central", , 2 March 2020 (2020-03-02), pages 1-3, XP093076447, Retrieved from the Internet: URL:https://www.mathworks.com/matlabcentral/answers/508615-how-to-fit-built-in-filter-functions [retrieved on 2023-08-26] * page 1 * ----- | 1-15 | |

TECHNICAL FIELDS
SEARCHED      (IPC)

The present search report has been drawn up for all claims

| Place of search | Date of completion of the search | Examiner |
|---|---|---|
| The Hague | 30 August 2023 | Jesus, Paulo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 ...............................................................................

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10447523 B2